Europäisches Patentamt

European Patent Office

Office européen des brevets

(11) Publication number: **0 449 418 A2**

## EUROPEAN PATENT APPLICATION

(21) Application number: **91301405.6**

(22) Date of filing: **21.02.91**

(51) Int. Cl.5: **H01L 29/10, H01L 29/784**

(30) Priority: **26.02.90 JP 47100/90**

(43) Date of publication of application:
**02.10.91 Bulletin 91/40**

(84) Designated Contracting States:
**AT BE CH DE DK ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Sakamoto, Shinichi**
**My Co-op, Room No. 105, 1341 Okada**
**Atsugi-shi, Kanagawa-ken(JP)**

(74) Representative: **Wright, Hugh Ronald et al**
**Brookes & Martin 52/54 High Holborn**
**London WC1V 6SE(GB)**

(54) Insulated gate field effect device with a curved channel and method of fabrication.

(57) An insulated gate field effect device comprising: a first conductivity type semiconductor substrate having a main surface, said semiconductor substrate having a concave with a curved surface formed on said main surface, an insulating film formed on the main surface including said concave, first and second impurity regions of a second conductivity type formed in the vicinity of said main surface of said semiconductor substrate, and at one side and the other side of said concave, respectively, said first conductivity type region of said semiconductor substrate between said first and second impurity regions having a channel region formed along said concave, and a conductive layer formed above said channel region with said insulating film interposed therebetween.

EP 0 449 418 A2

The invention relates generally to insulated gate field effect devices. Achievement of a longer effective channel length without increasing the occupying area for insulated gate field effect devices and a method of forming the same will be described.

As the high integration of semiconductor integrated circuit devices (IC) evolve, various problems arise. In insulated gate field effect devices, the following problems caused by the high integration are noted.

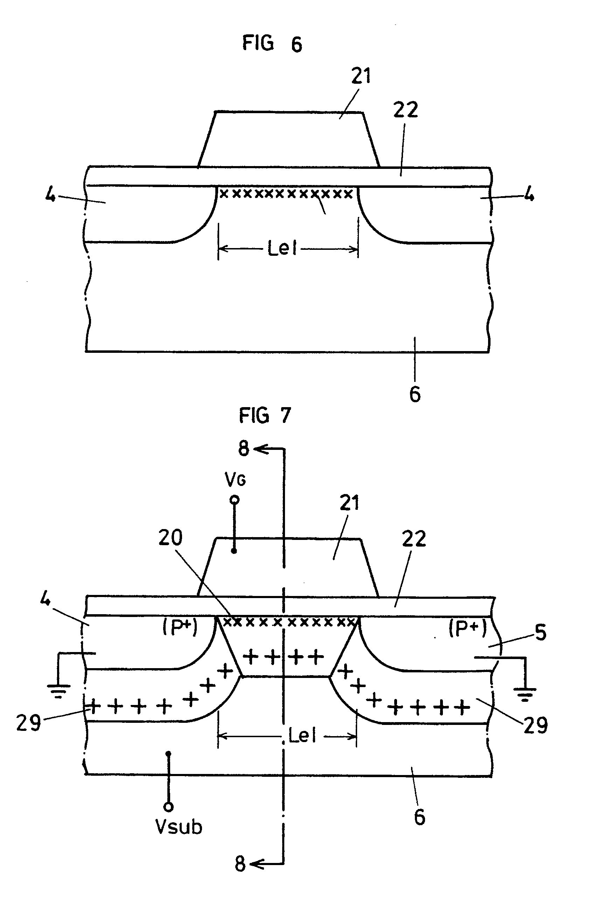

Figure 6 is a sectional view showing a structure of a conventional planar insulated gate field effect device. A MOS transistor is indicated in this figure. Referring to Figure 6, the MOS transistor comprises an n type semiconductor substrate e.g. an n type silicon substrate 6, a $p^+$ source 4 and a $p^+$ drain 5 each formed in the vicinity of the main surface of semiconductor substrate 6 by diffusion, a gate oxide film 22 formed on the main surface of substrate 6, and a conductive layer formed above the main surface of substrate 6 with an insulating film 22 interposed therebetween, i.e. a gate 21. A channel region 27 which is indicated by "x" in the figure is formed in the vicinity of the main surface between the source 4 and the drain 5. Since the length of the channel region will be slightly corroded by a diffusion for the formation of the source 4 and the drain 5, an effective channel length Le1 is obtained in practice.

Figure 7 is a structural sectional view showing the development of a depletion layer in the MOS transistor of Figure 6. Referring to Figure 7, the source 4 and the drain 5 are grounded to make definite the development of a depletion layer. Accordingly, a depletion layer 29 is formed so as to surround the source 4 and the drain 5. In addition, voltage VG is supplied to the gate 1 causing a depletion layer 20 with a trapezoid configuration to be formed under the gate 1 and between the depletion layers 29. In this case, the effective channel length Le1 is defined by the longer side of the trapezoid depletion layer 20. Substrate voltage Vs is supplied to the substrate 6.

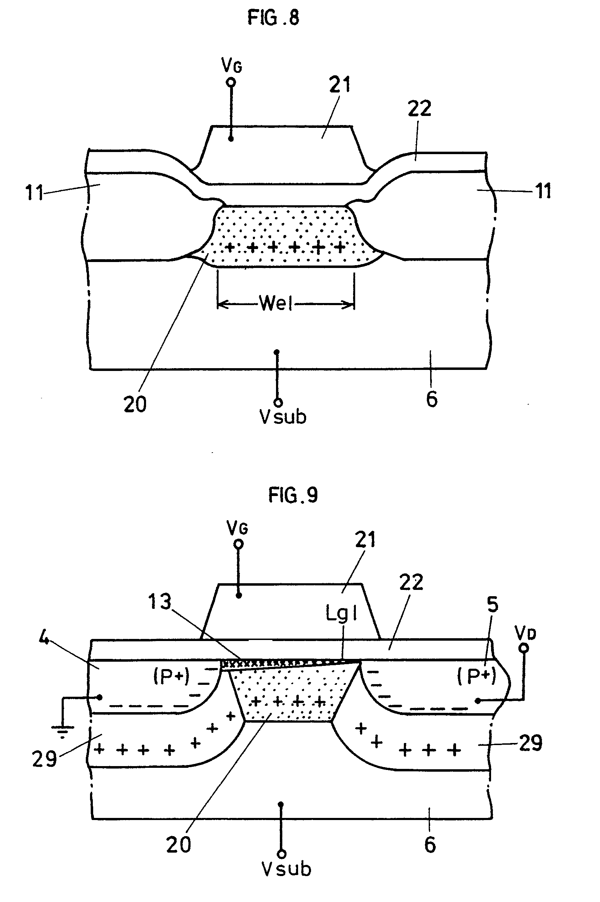

Figure 8 is a structural sectional diagram of the structure in Figure 7 when seen from the arrow 8. Referring to Figure 8, a depletion layer 20 having an effective channel width of We1 is formed between local oxidation of silicons (referred to as LOCOS hereinafter) 11 for element isolation.

Figure 9 is a structural sectional view showing the status when operating voltage is supplied to the MOS transistor of Figure 6. Referring to Figure 9, voltage VD is supplied to the drain 5, and voltage VG is supplied to the gate 1. The source 4 is grounded. It is seen from Figure 9 that the length of channel region 13 retracts from the drain 5 when the operating voltages VD and VG are supplied. In other words, between one end of the channel region 13 and the drain 5, there is a region of a length Lg1 without a channel being formed therein. This means that field concentration will occur in the vicinity of the main surface of the depletion layer 20 near the drain 5.

This field concentration will cause the following several problems. First, breakdown voltage will occur in the vicinity of the drain due to its field concentration resulting in current to flow into the substrate 6. This means that a greater voltage cannot be supplied to the gate 1 and the drain 5. In addition, electrons (hot electrons) accelerated by field concentration will flow into the gate oxide film 22 to cause degradation in withstand voltage of the gate oxide film 22. Summarizing the above description, it is pointed out that the voltage that can be supplied to the drain 5 (the drain withstand voltage) and the voltage that can be supplied to the gate 21 (the gate withstand voltage) are degraded.

Furthermore, since the depletion layer 20 has a trapezoid configuration as shown in Figure 9 (this phenomenon is called "fringe effect"), it is also noted that the current is not increased in proportion to the length of the gate. Ideally, the current flowing between the drain and the source increases in proportion to the length of the gate in an insulated gate field effect device. However, the above mentioned fringe effect will hinder the proportional increase of the current. That is to say, as the channel length shortens, threshold voltage Vt decreases. Therefore, subthreshold current will flow to the source 4 from drain 5 when the transistor should be turned off.

An insulated gate field effect device in accordance with the present invention comprises:

a first conductivity type semiconductor substrate having a main surface,

said semiconductor substrate having a concave with a curved surface formed on said main surface,

an insulating film formed on the main surface including said concave,

first and second impurity regions of a second conductivity type formed in the vicinity of said main surface of said semiconductor substrate, and at one side and the other side of said concave, respectively,

said first conductivity type region of said semiconductor substrate between said first and second impurity regions having a channel region formed along said concave, and

a conductive layer formed above said channel region with said insulating film interposed therebetween.

The present invention also provides a method of forming an insulated gate filed effect device on a first conductivity type semiconductor substrate having a main surface, comprising the steps of:

forming a concave having a curved surface at the main surface of said semiconductor substrate,

forming a first insulating film above the main surface including said concave,

forming a conductive layer above said concave having been formed in said semiconductor substrate, with said first insulating film interposed therebetween, and

forming first and second impurity regions of a second conductivity type at one side and the other side of said concave, respectively, in the vicinity of the main surface of said semiconductor substrate.

We will describe an insulated gate field effect device which has a channel region formed along a concave to obtain a longer effective channel length without an increase in the occupying area.

## BRIEF DESCRIPTION OF THE DRAWINGS

Figure 1 is a sectional view of the structure of a MOS transistor showing an embodiment of the invention.

Figure 2 is a structural sectional view showing the development of a depletion layer in the MOS transistor of Figure 1.

Figure 3 is a sectional structure view of the structure in Figure 2 when seen from a different direction.

Figure 4 is a structural sectional view of the state when operating voltages are supplied to the MOS transistor of Figure 1.

Figures 5A-5E are processing diagrams showing the formation of the MOS transistor of Figure 1.

Figure 6, already referred to, is a sectional view showing the structure of a conventional MOS transistor.

Figure 7, already referred to, is a structural sectional view showing the development of a depletion layer in the MOS transistor of Figure 6.

Figure 8, already referred to, is a structural sectional view of the structure in Figure 7 when seen from a different direction.

Figure 9, already referred to, is a structural sectional view showing the state when operating voltages are supplied to the MOS transistor of Figure 6.

In the figures, 1 is the gate, 2 is the gate oxide film, 4 is the source, 5 is the drain, 6 is the semiconductor substrate, 7 is the channel region, 9 and 10 are the depletion layer, Le1 and Le2 are the effective channel lengths.

## DESCRIPTION OF THE PREFERRED EMBODIMENT

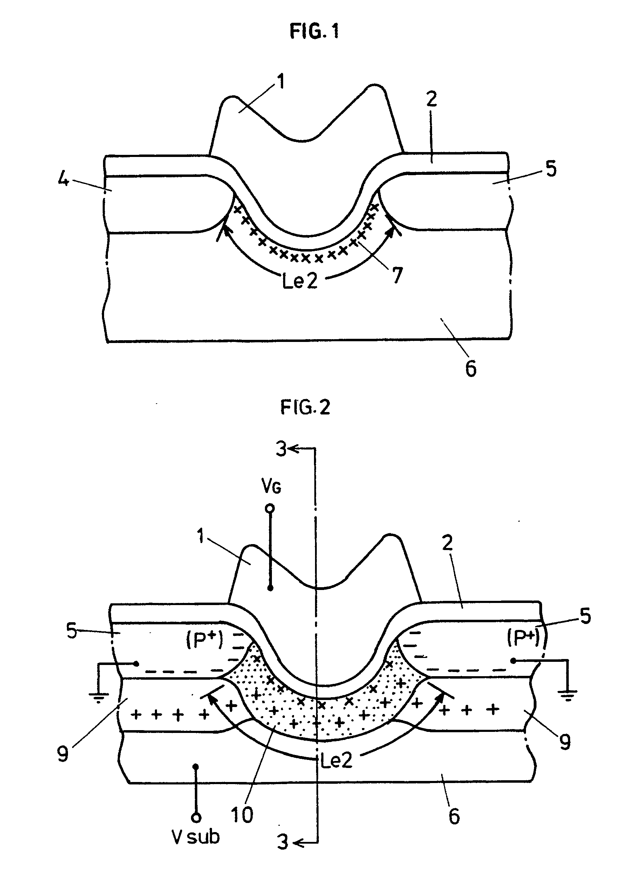

Figure 1 is a sectional view of a structure of an insulated gate field effect device showing an embodiment of the invention. In this figure, a MOS transistor is indicated by way of an example. Referring to Figure 1, the MOS transistor comprises a semiconductor substrate having a concave which is formed as a smooth curve, i.e. a silicon substrate 6, a source 4 and a drain 5 formed on one side and the other side of the concave by diffusion respectively, a gate oxide film 2 formed on the main surface of the substrate 6 including the concave, and a conductive layer formed on the concave, i.e. a gate 1. A channel region 7 is formed along the concave between the source 4 and the drain 5 to obtain an effective channel length Le2 that is longer than the effective channel length Le1 shown in Figure 6.

Figure 2 is a structural sectional view showing the development of a depletion layer in the MOS transistor of Figure 1. Referring to Figure 2, a source 4 and a drain 5 is provided to facilitate the development of the depletion layer. A depletion layer 9 is formed below the source 4 and the drain 5. Also, a depletion layer 10 is formed along the concave between the source 4 and the drain 5. When gate voltage VG is supplied, a channel region is formed in the depletion layer 10 along the concave.

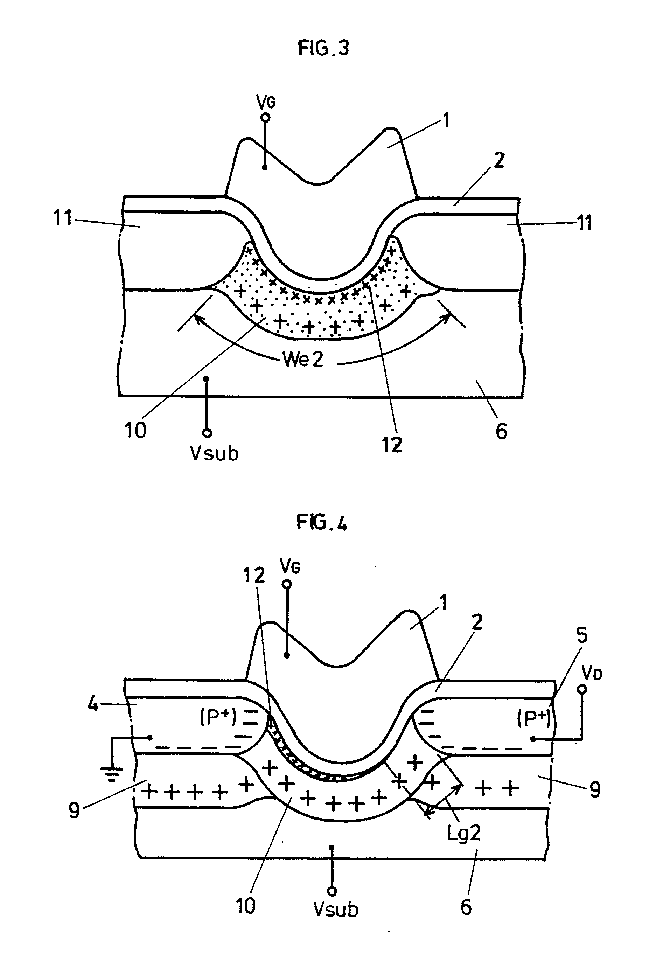

Figure 3 is a structural sectional view of the structure in Figure 2 when seen from the direction of the arrow 3. Referring to Figure 3, a depletion layer 10 is formed between LOCOS 11 along the concave when gate voltage VI is supplied. A channel region 12 having the effective channel width We2 is formed along the concave in the depletion layer 10.

Figure 4 is a structural sectional view showing the status when operating voltages are supplied to the MOS transistor of Figure 1. The MOS transistor of Figure 4 has the same operating voltages shown in Figure 9, that is, has gate voltage VG and drain voltage VD supplied. By comparing Figure 4 to Figure 9, it can be seen that the two MOS transistors have the same occupying area, except that the distance Lg2 between the end of channel region 12 and the drain 5 is longer than the distance Lg1 indicated in Figure 9. That is to say, since the effective channel length Le2 shown in Figure 1 is longer than the effective channel length Le1 shown in Figure 6, the field concentration in the vicinity of the drain is reduced as compared with that of the MOS transistor in Figure 6.

With the decrease of field concentration in the vicinity of the drain, electrons (hot electrons) accelerated by field concentration is prevented from flowing to the substrate 6 or the gate oxide film 2. Since the current flow to substrate 6 caused by voltage breakdown can be prevented, the degradation of the voltage to be supplied to the drain (the drain withstand voltage) may be avoided. In addition, the degradation of the voltage to be supplied to the gate oxide film 2 (the gate withstand voltage) may also be avoided.

Furthermore, a strip depletion layer 10 is formed along the concave as shown in Figures 2 and 4, resulting in a current flow which is proportional to the gate length. In conventional MOS transistors, a depletion layer 10 having a trapezoid configuration as shown in Figures 7 and 9 due to fringe effect is formed. On the contrary, a strip depletion layer 10 as shown in Figures 2 and 4 is obtained. Consequently, the effect of a short or a long effective channel length is reduced.

In addition, the variation of threshold voltage Vt caused by the variation of the supplied gate voltage can be prevented. As a result, the generation of the sub threshold current may also be avoided.

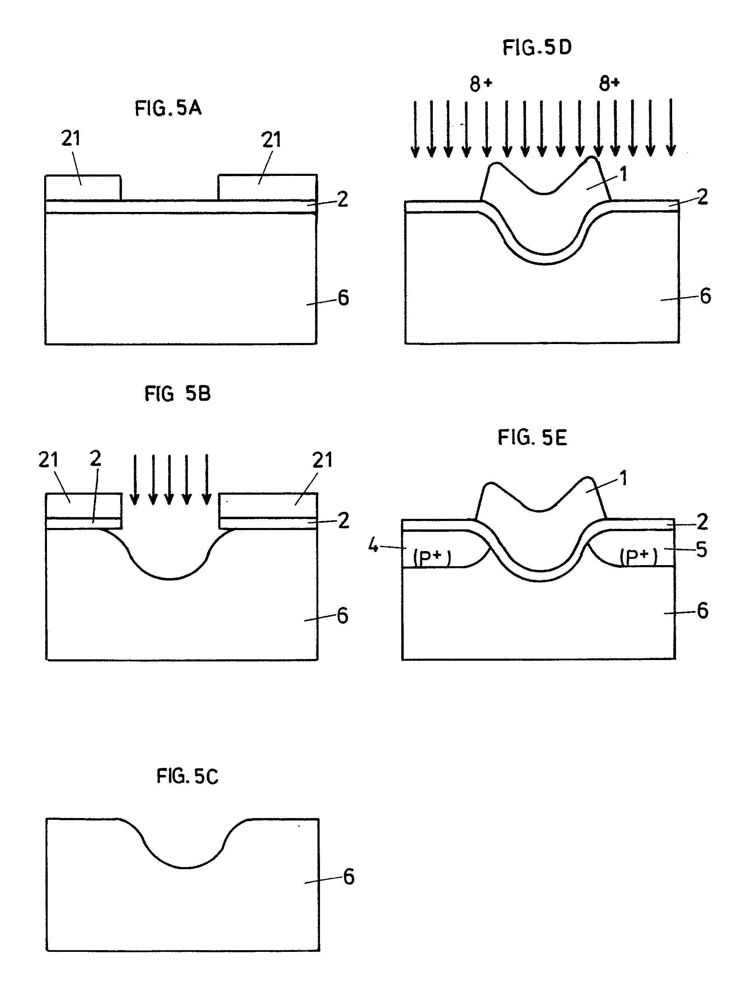

Figures 5A-5E are diagrams showing the process of forming the MOS transistor of Figure 1. Firstly, as shown in Figure 5A, an oxide film 2 is formed on a silicon substrate 6, followed by the formation of a patterned resist 21 on the oxide film 2. Then , as shown in Figure 5B, an isotropic etching such as plasma etching or focal ion beam (hereinafter referred to as EB) from above is performed to form a concave on the substrate 6. By removing the resist 21 and the oxide film 2, a silicon substrate 6 having a concave formed as shown in Figure 5C is obtained.

Next, as shown in Figure 5D, an oxide film 2 is formed on the substrate 6 including the concave portion, and a conductive layer 1 for constituting a gate is formed at the concave portion of the oxide film 2. By implanting boron ions $p^+$ from above into the substrate 6 to be diffused with thermal process, the MOS transistor shown in Figure 5E, i.e. an insulated gate field effect device having the structure shown in Figure 1 is obtained.

In the MOS transistor shown in Figure 1, the depth of the concave formed in the vicinity of the main surface of the substrate 6 is preferably set to the same value of the depth of the source 4 and the drain 5. The effect of the embodiment of this invention is most significant when the depth of the concave is set to a value which ranges between the depth of the source 4 and the drain 5 and its twofold. That is to say, when the depth of the drain is 0.5-0.6$\mu$m, the depth of the concave is set to a maximum of approximately 1.0$\mu$m. The effective channel length will be designed to lie within the range of 0.5 to 1.0$\mu$m, resulting in the achievement of a 0.7 to 1.4$\mu$m effective channel length in practice.

The configuration of the concave should preferably be smooth towards the direction of the drain 5 from the source 4. In other words, it is preferable to form a concave which is comprised of a curved surface. This is because if a concave which does not have a smooth configuration is formed, field concentration will occur at that portion.

In accordance with an embodiment of the present invention, a channel region is formed along a concave between first and second impurity regions to obtain an insulated gate field effect device having a longer effective channel length without increasing the occupying area.

## Claims

1. An insulated gate field effect device comprising:

   a first conductivity type semiconductor substrate having a main surface,

   said semiconductor substrate having a concave with a curved surface formed on said main surface,

   an insulating film formed on the main surface including said concave,

   first and second impurity regions of a second conductivity type formed in the vicinity of said main surface of said semiconductor substrate, and at one side and the other side of said concave, respectively,

   said first conductivity type region of said semiconductor substrate between said first and second impurity regions having a channel region formed along said concave, and

   a conductive layer formed above said channel region with said insulating film interposed therebetween.

2. An insulated gate film effect device according to claim 1, wherein one of said first and second impurity regions constitutes one of a source region and a drain region of said insulated gate field effect device,

   the other of said first and second impurity regions constitute the other of said source region and said drain region, and

   said conductive layer constitutes a gate electrode of said insulated gate field effect device.

3. An insulated gate field effect device according to claim 1, wherein the depth of said concave is set to a value which ranges between the depth of said first and second impurity regions and its twofold.

4. An insulated gate field effect device according to claim 1, which comprises a metal oxide semiconductor (MOS) transistor, and wherein said insulating film comprises an oxide film.

5. A method of forming an insulated gate filed effect device on a first conductivity type semiconductor substrate having a main surface, comprising the steps of:

forming a concave having a curved surface at the main surface of said semiconductor substrate,

forming a first insulating film above the main surface including said concave,

forming a conductive layer above said concave having been formed in said semiconductor substrate, with said first insulating film interposed therebetween, and

forming first and second impurity regions of a second conductivity type at one side and the other side of said concave, respectively, in the vicinity of the main surface of said semiconductor substrate.

6. A method of forming an insulated field effect device according to claim 5, wherein the step of forming said concave comprises the steps of:

forming a second insulating film on said semiconductor substrate,

forming a patterned resist layer on said second insulating film,

the configuration of said patterned resist conforming to the configuration of said concave,

performing isotropic etching to said semiconductor substrate from above said resist layer,

said semiconductor substrate having said concave formed at the main surface by said isotropic etching, and

removing said resist layer and said second insulating film.

## FIG. 1

## FIG. 2

## FIG.3

## FIG.4

FIG.5D

8+   8+

FIG.5A

21   21

2

6

FIG 5B

21   2   21

2

6

FIG. 5C

6

1

2

6

FIG. 5E

1

4  (P+)   (P+)   5

2

6

8

## FIG 6

## FIG 7

## FIG .8

## FIG.9